# EUROPEAN PATENT APPLICATION

(11) **EP 1 267 385 A1**
(43) Date of publication of application: **18.12.2002**
(21) Application number: 02253721.1
(22) Date of filing: 28.05.2002
(51) Int. Cl.: H01J 41/20, F04B 19/00

(54) **Micro ion pump for a low-pressure microdevice microenclosure**

(30) Priority: 11.06.2001 US 879286
(71) Applicant: Hewlett-Packard Company, Palo Alto, CA 94304 (US)
(72) Inventor: Schulte, Donald W., Corvallis, OR 97330 (US); McMahon, Terry E., Corvallis, OR 97330 (US); Edwards, Douglas Jay, Philomath, OR 97370 (US)
(74) Representative: Jackson, Richard Eric

(57) **Abstract**

A miniature ion pump (308, 310, 316, 318), and method for fabricating the miniature ion pump, that may be included within a low-pressure microdevice microenclosure (306). The miniature ion pump comprises two charge plates (308, 310) separated by a constant distance, fabricated by well-known microchip fabrication techniques, to which a voltage potential difference is applied in order to create a perpendicular electric field that ionizes gas molecules. The resulting positively charged ions are adsorbed to charge plates, thus removing gas molecules from the interior of the low-pressure microenclosure and maintaining a low-pressure environment surrounding the enclosed microdevice (302).

## Description

### TECHNICAL FIELD

The present invention relates to low-pressure microdevice microenclosures and, in particular, to a miniature ion pump fabricated by semiconductor fabrication techniques for inclusion in a low-pressure microdevice microenclosure.

### BACKGROUND OF THE INVENTION

During the past forty years, extremely precise, complex, and elegant methodologies have been developed in the field of semiconductor fabrication in order to mass produce complex integrated circuits used as processor and memory components within computers. Computer control is being applied to many different types of technological areas, and microchips and other devices produced by semiconductor fabrication techniques have become common components in a wide variety of electromechanical devices and systems, including automobiles, communications systems, machine tools, and many others. More recently, semiconductor fabrication techniques have been applied to the manufacture of tiny electromechanical devices in an emerging technological field referred to as micro-electromechanical systems ("MEMS").

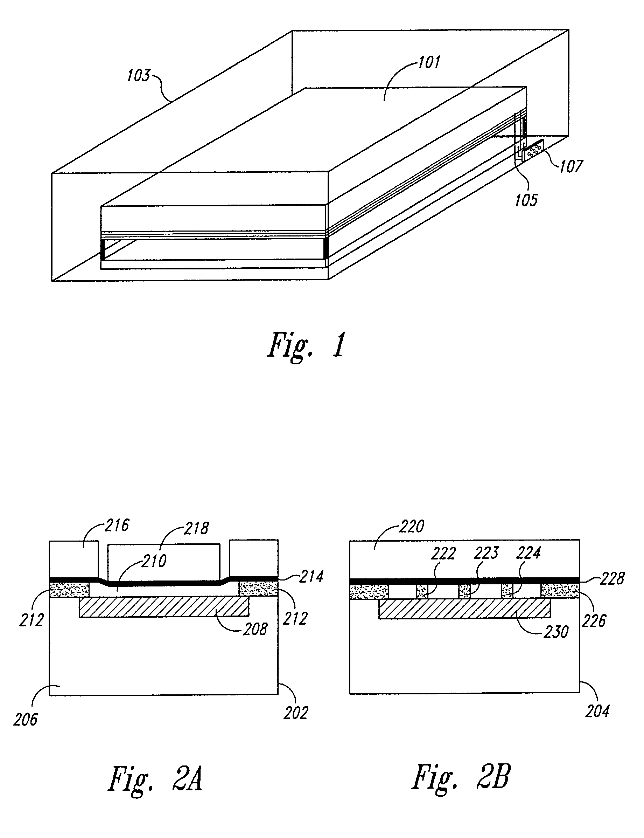

Certain MEMS devices require very low-pressure, partial-vacuum environments in which to operate. Figure 1 illustrates one type of low-pressure MEMS device. A microfabricated MEMS device 10 1 is enclosed within an airtight microenclosure 103 in order to maintain an internal low-pressure environment with internal pressures below 10⁻⁴ Torr. The microfabricated MEMS device 101 is coupled to external circuitry via internal signal lines 105 and a connector or adaptor 107. The microfabricated MEMS device 101 may be a microchip containing many hundreds or thousands of miniature mechanical, or electromechanical, components. The airtight microenclosure 103 may have linear dimensions on the order of a few inches to factions of an inch.

Although a low-pressure microenclosure can be manufactured with an internal pressure below 1 0⁻⁵ Torr, the pressure within a microenclosure may gradually increase with time due to leakage, sublimation of microenclosure or microdevice materials, or vaporization of metallic layers during operation of the microfabricated MEMS device within the microenclosure. Once the internal pressure rises above a certain threshold value, the performance of the enclosed MEMS device may degrade below acceptable performance ranges or fail altogether. Once performance of the enclosed MEMS device degrades, or the enclosed MEMS device fails, a device containing the enclosed MEMS device as a subcomponent may, in turn, suddenly fail.

A number of different MEMS pressure-related devices, including MEMS pressure sensors, have been developed. Figures 2A-B show two parts of a typical MEMS pressure-sensing device. The pressure sensing device relates the difference in capacitance between a sensor cell, shown in Figure 2A, and a reference cell, shown in Figure 2B, to the pressure within an environment containing the MEMS pressure sensor. The MEMS pressure sensor device is fabricated by standard semiconductor fabrication techniques from doped silicon substrates, silicon dioxide layers, and empty cavities etched out from between silicon dioxide and doped silicon layers. The sensor cell 202 and reference cell 204 are quite similar in structure. The sensor cell 202 comprises ap-type silicon substrate 206 in which an n-well 208 is formed by standard semiconductor fabrication techniques. An empty cavity 210 lies above the surface of the n-well 208. The walls of the cavity are formed from a field oxide layer 212. A thin elastic diaphragm 214 comprising a poly silicon layer overlies the empty cavity. An additional silicon dioxide layer 2 16 lies above the elastic diaphragm 2 14. The additional silicon dioxide layer 2 16 is etched to produce a rectangular boss 2 18 resting on the elastic diaphragm 2 14 above the empty cavity 2 10. Environmental pressure pushes the boss, and diaphragm on which it rests, inward into the empty cavity 2 10 until the pressure within the empty cavity 2 10 is equal to the environmental pressure. The elastic diaphragm 214 and n-well 208 together form parallel plates of a capacitor, and the amount of charge stored within the capacitor for a given voltage differential applied to the parallel plates is inversely proportional to the distance between the plates. The reference cell 204 is nearly identical to the sensor cell, with the exception that the top silicon dioxide layer 220 of the reference cell is not etched to create a boss, and additional columns 222-224 are left in the field oxide layer of the reference cell 226 so that the diaphragm 228 of the reference cell remains at a constant distance from the n-well 230 of the reference cell. By measuring the difference in the charge stored within the reference cell capacitor to the charge stored within the sensor cell capacitor, the inward displacement of the boss 2 18 within the sensor cell relative to the distance between the diaphragm 228 and the n-well 230 of the reference cell the can be electronically measured. The measured displacement is then directly related to the environmental pressure surrounding the sensor cell.

Manufacturing techniques exist for producing an initial low-pressure environment within a low-pressure microenclosure, such as low-pressure mircorenclosure 3 10. However, it is currently impossible to ensure that, over time, significant depressurization of the low-pressure microenclosure does not occur due to leakage, sublimation of microenclosure and chip materials, and vaporization of chip and target materials during operation of the microfabricated field emitter tip array. Currently, there are no acceptable methods for reestablishing a low-pressure environment within a low-pressure microenclosure without removing the low-pressure microenclosure from a device in which is included. Currently available low-pressure pumps, are far too large to include within a low-pressure microenclosure, and including such pumps externally within macro-electromechanical devices that employ low-pressure MEMS devices would be prohibitively expensive and add unacceptable levels of complexity to the macro-electromechanical devices. Moreover, currently available micro pressure sensors, such as the micro pressure sensor discussed with reference to Figure 2, are not sufficiently sensitive to pressures below 1 0⁻⁴ Torr, required for operation of certain low-pressure MEMS devices. Therefore, not only is it currently impossilble to economically reestablish low-pressure environments within low-pressure microenclosures, it is currently impossible to accurately monitor the pressure within low-pressure microenclosures. Designers and manufacturers of microfabricated MEMS devices, and other microelectronic devices enclosed within low-pressure microenclosures, have thus recognized the need for a method and system for economically maintaining and monitoring the low-pressure environment within the low-pressure microenclosures following manufacture.

### SUMMARY OF THE INVENTION

One embodiment of the present invention is a miniature ion pump, manufactured by well-known microchip fabrication techniques, that can be included within a low-pressure microenclosure. The miniature ion pump includes two microfabricated charge plates, a first charge plate affixed to, or fabricated on, the inside of the low-pressure microenclosure, and a second charge plate affixed to, or fabricated on, a surface of a microfabricated microelectronic device enclosed within the low-pressure microenclosure, so that a constant separation is maintained between the two charge plates following manufacture of the microelectronic device enclosed within the low-pressure microenclosure. By applying a high voltage potential differential to the charge plates, an electric field is produced between the charge plates. Gas molecules are ionized in the electric field and adsorbed to a charge plate, removing the gas molecules from the low-pressure microenclosure and thus maintaining the low-pressure environment.

### BRIEF DESCRIPTION OF THE DRAWINGS

Figure 1 illustrates one type of low-pressure MEMS device.
Figures 2A-B show two parts of a typical MEMS pressure-sensing device.
Figure 3 shows a low-pressure microdevice microenclosure containing a microchip and a miniature ion pump.

### DETAILED DESCRIPTION OF THE INVENTION

One embodiment of the present invention is a miniature ion pump that can be included within a low-pressure microdevice microenclosure in order to maintain a low-pressure environment, less than 10⁻⁴ Torr, surrounding a microfabricated MEMS device or other microelectronic device mounted within the low-pressure microdevice microenclosure. The miniature ion pump is operated by applying a large voltage potential difference to two charge plates separated from one another by a constant distance. The electric field strength between the charged plates is proportional to the differential voltage and inversely proportional to the distance between the plates. Thus, the electric field strength can be determined by positioning of the charge plates and the applied voltage, and can be selected from among a wide range of possible electric field strengths in order to produce sufficient ionization and adsorption of gas molecules to maintain the pressure within the low-pressure microenclosure at or below a desired maximum pressure.

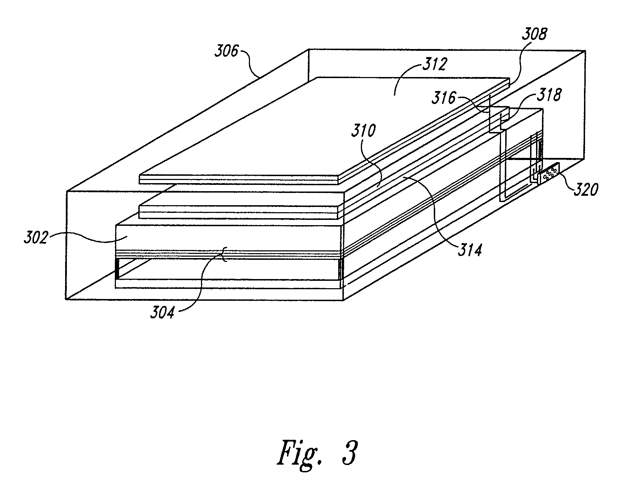

Figure 3 shows a low-pressure microdevice microenclosure containing a microchip and a miniature ion pump. The microchip is a microfabricated field emitter tip array 302 with alternating metallic and dielectric layers 304. In addition, a miniature ion pump has been added to the low-pressure microenclosure 306. The miniature ion pump includes a first charge plate 308 and a second charge plate 3 10. The first charge plate 308 is layered on top of a dielectric layer, such as a SiO₂ layer 3 12, that is, in turn, affixed to, or deposited on, an inner surface of the low-pressure microenclosure 306. The second charge plate 3 10 is layered on top of a SiO₂ dielectric layer 3 14 deposited on a horizontal surface of the microfabricated field emitter tip array 302. Electrical contacts 3 16 and 3 18 are added to couple the charge plates 308 and 3 10 to an external plug or coupler 320. In one embodiment, the voltage potential of the two charge plates 308 and 3 10 is supplied through distinct electrical connections from those that produce the voltage potentials in the alternating metal and dielectric layers 304 of the microfabricated field emitter tip array 302. In an alternate embodiment, a common voltage may be supplied to the second charge plate 3 10 and to the base cathode for the field emitter tip.

The miniature ion pump operates by ionizing gas molecules in the electric field produced between the charged plates 308 and 3 12. The positive ions produced from the gas molecules are then adsorbed to the surface of the more negatively charged charge plate. Thus, the surface area of the charged plates determines, in part, the length of time for which the miniature ion pump can operate to maintain a low-press environment within the low-pressure microenclosure. In order to increase the surface area of the charge plates, the charge plates may be fabricated to have a pattern of varying thickness, in one embodiment regularly spaced grooves and peaks similar to a diffraction grating, in order to increase the area of the surfaces of the charged plates.

In one embodiment, the charged plates are titanium layers deposited by chemical or physical vapor deposition techniques well-known in the microchip fabrication industry. The underlying dielectric layer in this embodiment is a layer of silicon dioxide, deposited by tetraethyl orthosilicate-based deposition methods, or thermally grown as a surface layer on the underlying silicon substrate.

The miniature ion pump may also serve as a pressure sensor. Ionized gas molecules adsorbed to the surface of the more negatively charged charge plate contribute a small, but detectable, ion-induced current to an electric circuit to which the miniature ion pump is coupled. The magnitude of the ion-induced current is directly related to the rate of adsorption of positively charged gas molecule ions, and hence to the internal pressure within the low-pressure microenclosure containing the miniature ion pump. Thus, the miniature ion pump may concurrently serve both to remove gas molecules from the interior of the low-pressure microenclosure as well as to monitor the internal pressure within the low-pressure microenclosure. In order to increase pressure detection sensitivity, a fixed magnet may be included to induce electrons to travel in spiral paths, increasing their cross sectional area for collision with gas molecules, and thus increasing the rate of gas molecule ionization.

Although the present invention has been described in terms of a particular embodiment, it is not intended that the invention be limited to this embodiment. Modifications within the spirit of the invention will be apparent to those skilled in the art. For example, different metals and metal alloys may be employed in the charge-plate layers of the miniature ion pump. Different dielectric materials may be used for the underlying dielectric layer. Low-pressure microenclosures of various shapes and sizes may be equipped with miniature ion pumps of corresponding shapes and sizes. The charge plates can be electrically coupled to external voltage sources by a variety of different methods well known in semiconductor fabrication and microelectronics. In the disclosed embodiment, a microfabricated field emitter tip array is enclosed within the low-pressure microenclosure, but many other types of microelectronic devices can be similarly packaged, along with the miniature ion pump. Detection of rising internal pressures within a low-pressure microenclosure via the current detection circuit within the described miniature ion pump may trigger reporting or display of the rising pressure on an audio or graphical display device or may automatically invoke warning and self-correction features within a device that includes the low-pressure microenclosure as a subcomponent.

The foregoing description, for purposes of explanation, used specific nomenclature to provide a thorough understanding of the invention. However, it will be apparent to one skilled in the art that the specific details are not required in order to practice the invention. The foregoing descriptions of specific embodiments of the present invention are presented for purpose of illustration and description. They are not intended to be exhaustive or to limit the invention to the precise forms disclosed. Obviously many modifications and variations are possible in view of the above teachings. The embodiments are shown and described in order to best explain the principles of the invention and its practical applications, to thereby enable others skilled in the art to best utilize the invention and various embodiments with various modifications as are suited to the particular use contemplated. It is intended that the scope of the invention be defined by the following claims and their equivalents:

## Claims

1. A micro ion pump (308, 310, 316, 318) included within a low-pressure microenclosure (306), the micro ion pump comprising:
a first charge plate (308);
a second charge plate (310) separated from the first charge plate by a distance; and
a circuit (316, 318) coupled to the first charge plate and the second charge plate that establishes a voltage potential differential between the first charge plate and the second charge plate, the voltage potential differential inducing an electric field in which gas molecules within the low-pressure microelectronic device collide with electrons accelerated in the electric field to produce ions that are accelerated in a direction opposite to the electrons so that the ions adsorb to the more negative of the first and secondcharge plates.

2. The micro ion pump (308, 310, 316, 318) of claim 1 wherein the first charge plate (308) is fabricated by well known microchip fabrication techniques, including metal layer deposition techniques, on an inner surface of the low-pressure microenclosure (306) and wherein the second charge plate (310) is fabricated by the well known microchip fabrication techniques on a surface of a microelectronic device (302) mounted within the low-pressure microenclosure (306).

3. The micro ion pump (308, 310, 316, 318) of claim 3 wherein the first charge plate (308) and the second charge plate (310) comprise a metal layer deposited on a dielectric substrate.

4. The micro ion pump (308, 310, 316, 318) of claim 1 wherein the metal layer comprises one of: titanium; and titanium alloy.

5. The micro ion pump (308, 310, 316, 318) of claim 1 wherein the more electrically negative charge plate of the first charge plate and the second charge plate is fabricated to have surface features to increase the surface area of the charge plate.

6. The micro ion pump (308, 310, 316, 318) of claim 1 wherein the micro ion pump maintains internal pressure of the low-pressure microenclosure below 10⁻⁴ Torr.

7. The micro ion pump (308, 310, 316, 318) of claim 1 wherein the circuit (316, 318) includes a current detection circuit that detects ion-induced current provided by ionized gas molecules.

8. The micro ion pump (308, 310, 316, 318) of claim 7 wherein the detected ion-induced current is related to a detected internal pressure within the low-pressure microenclosure (306) by a pressure sensing circuit, wherein the detected internal pressure is reported on a reporting device, and wherein a high detected internal pressure invokes a warning system.

9. A method for maintaining a high-vacuum within a low-pressure microenclosure (306), the method comprising:
including a first charge plate (308) and a second charge plate (310) within the low-pressure microenclosure (306), the second charge plate separated from the first charge plate by a distance within the low-pressure microelectronic device microenclosure;
coupling a circuit (316, 318) to the first charge plate and the second charge plate; and
applying a voltage potential differential between the first charge plate and the second charge plate via the circuit, the voltage potential differential inducing an electric field in which gas molecules within the low-pressure microelectronic device collide with electrons accelerated in the electric field to produce ions that are accelerated in a direction opposite to the electrons so that the ions adsorb to the more negative of the first and second charge plates.

10. The method of claim 12 wherein adsorption of ions to the more negative of the first (308) and second (310) charge plates maintains internal pressure of the low-pressure microenclosure (306) below 10⁻⁴ Torr.
